# EUROPEAN PATENT APPLICATION

(11) **EP 0 742 622 A2**
(43) Date of publication of application: **13.11.1996**
(21) Application number: 96104767.7
(22) Date of filing: 26.03.1996
(51) Int. Cl.: H01S 3/19

(54) **Laser diode**

(30) Priority: 27.03.1995 JP 67892/95
(71) Applicant: Mitsubishi Cable Industries, Ltd., Amagasaki-shi Hyogo 660 (JP)
(72) Inventor: Watabe, Shinichi, Maebaru-shi, Fukuoka 819-11 (JP); Tadatomo, Kazuyuki, 3, Ikejiri 4-chome, Itami-shi, Hyogo 664 (JP)
(74) Representative: von Kreisler, Alek, Dipl.-Chem.

(57) **Abstract**

A laser diode comprising an electro-conductive substrate (1), an electrode (4) formed on one side thereof, a stripe light emitting part (2) having a double heterostructure formed on the other side of the substrate, and the other electrode (5) formed on said light emitting part (21), wherein the light emitting part (2) comprises a first cladding layer (2a), an active layer (2c) composed of a compound semiconductor of the formula: InₓGa_{y}Al_{1-x-y}N (0≦x≦1, 0≦y≦1) and a second cladding layer (2b) in that order from the substrate side, and the stripe light emitting part (2) is buried with a burying material (3a,3b) having a high electric resistance and preferably also having an effective refractive index which is 5×10⁻¹ - 5×10⁻⁴ lower than the effective refractive index of the active layer (2c) at a lasing wavelength. According to the present invention, an InGaAlN laser diode having an improved injection density of the current into the active layer (2c), which is capable of suppressing the occurrence of higher order mode and which has superior heat releasability can be provided. The laser diode of the present invention is advantageous in that it facilitates production and reduces the production costs.

## Description

### FIELD OF THE INVENTION

The present invention relates to an edge emission type laser diode. More particularly, the present invention relates to a laser diode having a light emitting part composed of an InGaAlN compound semiconductor.

### BACKGROUND OF THE INVENTION

To meet the demand for an increased density of the data to be conveyed in communication and records, a laser diode capable of emitting light of blue to ultraviolet short wavelength regions is desired. As the semiconductor material for such laser diodes, compound semiconductors composed of III group elements and nitrogen, in particular, compound semiconductors of the formula: InₓGa_{y}Al_{1-x-y}N (0≦x≦1, 0≦y≦1) have been drawing attention (hereinafter said compound semiconductor is to be referred to briefly as InGaAlN compound semiconductor).

The substrate of such laser diodes has been conventionally made exclusively from sapphire crystals which can be obtained easily. The laser diodes generally include gain-guiding laser diodes and refractive index-guiding laser diodes which have a wave guide structure according to the differences in refractive index. The InGaAlN compound semiconductors are mostly the latter, refractive index-guiding laser diodes, in which an injection current density can be increased with ease.

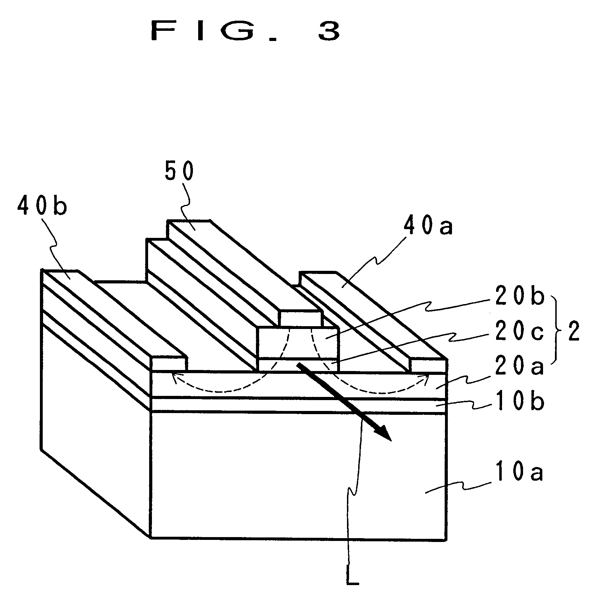

Fig. 3 shows a conventional refractive index-guiding type InGaAlN laser diode comprising a substrate prepared from sapphire crystals. In this figure, a double heterostructure light emitting part 2 is laminated on one side of a sapphire crystal substrate 10a via a buffer layer 10b. This light emitting part 2 consists of a lower cladding layer 20a, an active layer 20c and an upper cladding layer 20b. An optical cavity is defined by the front plane and the rear plane in Fig. 3, and a laser light L is emitted in the direction shown by a thick arrow.

Sapphire crystals are electrically insulating and an electrode (e.g., an n-side electrode) cannot be formed on the rear side of the substrate 10a. Hence, as shown in Fig. 3, the upper surface of the lower cladding layer 20a is exposed to form n-side electrodes 40a and 40b thereon. A p-side electrode 50 is formed on the upper surface of the upper cladding layer 20b, and the side walls of the light emitting part 2 come into direct contact with the air.

The refractive index-guiding type InGaAlN laser diodes having the aforementioned structure are associated with various problems mentioned below.
(1) The current under application of voltage between the p-electrode and n-electrode flows not in the direction vertically penetrating the substrate 10a, but in the transverse direction through the lower cladding layer 20a, as shown in Fig. 3 with a broken line arrow, which in turn leads to an insufficient density of the current injected into the active layer 20c.
(2) The side walls of the light emitting part 2 are in contact with the air. The noticeably great difference in refractive index between the materials of the active layer 20c and the air frequently causes a higher order mode due to an excessive optical confinement effect.
(3) A so-called upside-down mounting is generally employed wherein the p-side electrode 50 is welded to a heat sink to deal with the heat generated in the light emitting part upon current injection. As a result, the heat in the active layer is released into the heat sink via the upper cladding layer 20b and the p-side electrode 50. In the conventional structure as shown in Fig. 3, however, both electrodes and electrical wirings therefor are formed only on one side of the substrate, and therefore, the heat sink needs to be welded to the p-side electrode 50 alone. This in turn necessitates prevention of short circuit, etc., thus making the upside-down mounting step complicated:

### SUMMARY OF THE INVENTION

It is therefore a primary object of the present invention to provide an InGaAlN laser diode having an improved injection density of the current into the active layer.

Another object of the present invention in to provide a refractive index-guiding type InGaAlN laser diode capable of suppressing the occurrence of a higher order mode.

A still another object of the present invention is to provide an InGaAlN laser diode which permits easy upside-down mounting and which has superior heat releasability.

Other objects of the present invention will be readily understood by those of ordinary skill in the art from the detailed description of the invention and working examples given in the following.

The laser diode of the present invention comprises an electro-conductive substrate, an electrode formed on one side thereof, a stripe light emitting part having a double heterostructure formed on the other side of the substrate, and the other electrode formed on said light emitting part. The light emitting part comprises a first cladding layer, an active layer composed of a compound semiconductor of the formula: InₓGa_{y}Al_{1-x-y}N (0≦x≦1, 0≦y≦1) and a second cladding layer in that order from the substrate side, and the stripe light emitting part is buried with a burying material having a high electric resistance. In the preferred embodiment of the present invention, said burying material has an effective refractive index n_{b} which is 5×10⁻¹ -5×10⁻⁴ lower than the effective refractive index nₐ of the active layer at a lasing wavelength.

The above-mentioned construction affords the following effects.
(A) The use of a conductive substrate enable installation of two electrodes sandwiching the substrate from above and below, thereby, flowing the current through the entirety of the light emitting part in the direction vertically penetrating the light emitting part. Combined with the light emitting part buried with a burying material having a high electric resistance capable of functioning the stripe light emitting part, the injection efficiency of the current into the light emitting part, therefore laser output, can be increased.
(B) When the burying material has, besides the high electric resistance, an effective refractive index n_{b} which is 5×10⁻¹ -5×10⁻⁴ lower than the effective refractive index nₐ of the active layer at a lasing wavelength, an appropriate optical confinement effect can be achieved, unlike the conventional structure shown in Fig. 3 wherein the light emitting part is in contact with the air, as a result of which occurrence of higher order mode can be suppressed.
(C) The electrodes formed on and beneath the electro-conductive substrate and the burying structure make it possible to easily upside-down mount the entire upper surface of the other electrode formed on the second cladding layer without the fear of short circuits apprehended in the structure of Fig. 3 and to improve the heat releasability.

### BRIEF EXPLANATION OF THE DRAWINGS

Fig. 1 is a perspective view of one embodiment of the laser diode of the present invention.

Fig. 2 is a perspective view of another embodiment of the laser diode of the present invention.

Fig. 3 is a perspective view of a conventional InGaAlN laser diode.

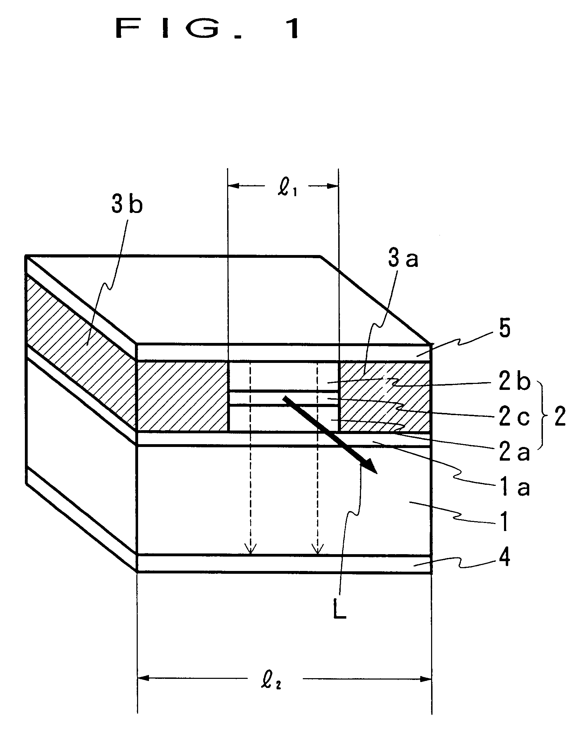

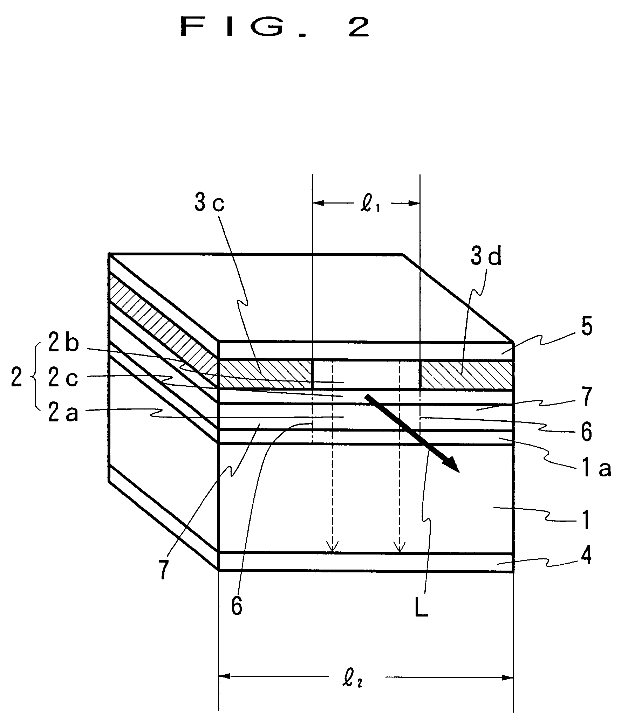

In Figs. 1 and 2, the like reference numerals represent like parts.

### PREFERABLE EMBODIMENTS OF THE INVENTION

In Fig. 1, an n-side electrode 4 is formed beneath a conductive substrate 1, and a light emitting part 2 is formed on the upper surface of the substrate 1 via a buffer layer 1a. The light emitting part 2 has a double heterostructure wherein an active layer 2c is sandwiched between an n-type first cladding layer 2a and a p-type second cladding layer 2b. The light emitting part as a whole has a stripe structure and is formed on the center of the substrate 1 as shown in Fig. 1. The light emitting part is sandwiched between two abutting burying materials 3a and 3b having a high electric resistance and the aforementioned specific effective refractive index n_{b}. The upper surface of the light emitting part 2 and the upper surface of the burying materials 3a and 3b form a flat plane, on which a p-side electrode 5 is formed in the entirety of the plane. The optical cavity is defined by, like that shown in Fig. 3, the front plane and the rear plane, and a laser beam is emitted in the direction of a thick arrow L. The current flow path is shown by the broken line in Fig. 1 between the electrodes in the perpendicular direction relative to the three layers of the light emitting part 2.

Each layer of the light emitting part 2 is prepared from at least one member selected from the compound semiconductors of the formula InₓGa_{y}Al_{1-x-y}N (0≦x≦1, 0≦y≦1), and is capable of emitting the light of blue to ultraviolet short wavelength regions.

Of the InGaAlN compound semiconductors, the combinations of the materials of cladding layer and active layer, which are particularly preferable for the emission of the light of blue to ultraviolet wavelength regions, are GaAlN/InGaN, GaAlN/GaN, GaAlN/GaAlN, InGaAlN/InGaN, InGaAlN/GaN, InGaAlN/GaAlN and InGaAlN/InGaAlN in the order of cladding layer material/active layer material. Of these combinations, those wherein the cladding layer material and active layer material consist of the same elements (e.g., GaAlN/GaAlN) have different composition ratios of the both materials. The composition is such that the band gap of the cladding layer is greater than that of the active layer.

Of the materials for the cladding layer, a compound semiconductor of the formula Ga₁₋ₓAlₓN (0≦x≦0.5) is particularly preferable from the aspects of high output and reduction of threshold current.

In general terms, when an InGaAlN compound semiconductor, particularly the above-mentioned Ga₁₋ₓAlₓN compound semiconductor, is used as a cladding layer material, an n-type dopant is preferably Si which permits easy control of carrier concentration. As the p-type dopant, for example, Mg and Zn are used. Doping alone of these p-type dopants does not render the InGaAlN compound semiconductor a p-type semiconductor, but merely converts same into a semiconductor having a high resistance. Accordingly, electron beam irradiation, heat treatment in an inert gas atmosphere (e.g., nitrogen), and the like are applied after doping to give a p-type semiconductor.

As the material for the active layer 2c, a compound semiconductor of the formula In₁₋ₓGaₓN (0.7≦x≦0.96) from among the compound semiconductors of the above-mentioned formula is particularly preferably used without dopants.

When combining a cladding layer material and an active layer material, the refractive index of the active layer is preferably designed to be greater than that of the cladding layer, whereby the light is efficiently confined in the active layer.

The double heterostructure of the light emitting part 2 may be, besides the typical structure consisting of three layers as shown in Fig. 1, SQW (single quantum well), MWQ (multi quantum well) and the like. In addition, SCH (separate confinement heterostructure) may be employed wherein, in general, the active layer is sandwiched between two cladding layers and also has a light emitting layer sandwiched between two waveguide layers. When SCH is employed, the difference Δ, that is, nₐ-n_{b} to be mentioned below, in the effective refractive index is considered between the effective refractive index n_{b} of the burying material and the effective refractive index nₐ of the waveguide layer in the active layer.

The light emitting part 2 has a stripe structure, and has a certain width l₁ as shown in Figs. 1 and 2. The light emitting part 2 is preferably located in the middle part of the substrate 1 having a width l₂. In general, the substrate width of l₂ is about 100-1,000 µm and the width l₁ of the stripe structure is about 0.05-50 µm, particularly preferably about 2-10 µm.

The substrate 1 may be any as long as it can be a base for forming an InGaAlN semiconductor layer, has electro-conductivity and permits an electrode to be formed on the surface. Examples thereof include crystals, preferably GaN, SiC and ZnO, and particularly preferably single crystals of GaN and SiC. The reflecting surface of the optical cavity is formed by reactive ion etching when a conventional sapphire substrate is used, since a reflecting surface cannot be formed by cleaving. In the present invention, an electro-conductive substrate 1 composed of cleavable single crystals such as GaN and SiC is advantageous in that an ideal mirror surface can be formed with ease utilizing the cleavability thereof, on the both ends of the light emitting part. The cleaved surface may be coated with one or more suitable dielectric thin layers to control the reflectance.

The buffer layer 1a consists of GaN and is formed as necessary as a layer to improve the crystal quality of an InGaAlN semiconductor layer when forming said layer on the crystal substrate 1. While the substrate 1 has an n-type conductivity in the embodiment shown in Fig. 1, it may be a p-type conductivity. The conducting type of the first and the second cladding layers is changed in accordance therewith.

The method for forming the stripe light emitting part 2 is exemplified in the following.

A buffer layer 1a is formed as necessary on the electro-conductive substrate 1, and the first cladding layer 2a (e.g., GaAlN) having the same conducting type with the substrate, active layer 2c (e.g., undoped InGaN) and the second cladding layer 2b (e.g., GaAlN) having a different conducting type from the substrate are successively formed thereon. To achieve the p-type conductivity, a post-treatment such as heat treatment and electron beam irradiation is applied after crystal growth where necessary. Then, a mask is formed on the upper surface of the light emitting part by photolithography, which is subjected to etching by RIE to give the stripe light emitting part 2.

The burying materials 3a and 3b are deposited on the entire surface of the buffer layer 1a up to the same level with the second cladding layer 2b so as to air-tightly cover the entire sides of the stripe light emitting part. The method of deposition may be a conventional one, with preference given to CVD and sputtering. When the InGaAlN compound semiconductor to be mentioned later is used as the burying material, it is preferably formed in the same manner as layers 2a and 2c.

The burying materials 3a and 3b serve both functions of an electric resistance function for efficiently injecting, into the active layer 2c, the current under application of the voltage between the electrodes 4 and 5, through the path shown with a broken line in Fig. 1, and a function of suppressing the occurrence of higher order mode from the active layer 2c. The electric resistance thereof is not less than 10⁴Ω cm, preferably not less than 10⁵Ω cm, and particularly preferably not less than 10⁶Ω cm. The materials 3a and 3b have, for the function of suppressing the occurrence of higher order mode, an effective refractive index n_{b} which is 5×10⁻¹ -5×10⁻⁴ lower than the effective refractive index nₐ of the active layer at a lasing wavelength. The value obtained by subtracting n_{b} from nₐ, namely, the difference Δ in effective refractive index, is preferably about 5×10⁻² - 5×10⁻³, particularly preferably about 1×10⁻² - 5×10⁻³.

The burying material is exemplified by inorganic oxides, such as SiO₂ (1.4-1.5), MgO (1.7), Al₂O₃ (1.7-1.76), P₂O₅ (1.47), B₂O₃ (1.48-1.64), ZnO (2.0), GeO₂ (1.65) and ZrO₂ (2.1) wherein the figure in the parenthesis is approximate refractive index of each substance, and compound semiconductors of the formula InₓGa_{y}Al_{1-x-y}N (0≦x≦1, 0≦y≦1), such as GaN, InGaN and GaAlN. In particular, the above-mentioned compound semiconductors are beneficial in that the burying materials having various effective refractive indices n_{b} can be obtained by varying the composition. For example, the materials having the designed band gap and effective refractive index can be obtained by adjusting X and Y therein. The undoped materials having the least possible amount of impurities or those doped with acceptor impurities such as Mg and Zn have preferable high electric resistance and can be produced easily. The doped materials of the latter can acquire high electric resistance with ease by merely doping. Examples of the compound semiconductor include In_{0. 02}Ga_{0. 98}N wherein Mg is doped at 1×10¹⁹ cm⁻³ (material having high electric resistance and n_{b} of 2.53 at wavelength of 410 nm at room temperature) and Ga_{0. 98}Al_{0. 04}N wherein Mg is doped (material having high electric resistance and n_{b} of 2.50 under the same conditions).

When the active layer 2c is formed from InGaN having an nₐ of 2.54 and the cladding layers 2a and 2b are formed from, for example, GaAlN having an n_{b} of 2.45, the burying materials 3a and 3b preferably have an effective refractive index n_{b} of less than 2.54 and are formed from, for example, SiO₂, ZnO, ZrO₂, In_{0. 02}Ga_{0. 98}N and Ga_{0. 98}Al_{0. 04}N. Of these, the materials other than SiO₂ are preferable in that the difference Δ in effective refractive index falls within the appropriate range.

When the light emitting part 2 has an SCH structure comprising a waveguide layer formed from, for example, GaN having an nₐ of 2.52 and the cladding layers 2a and 2b formed from, for example, GaAlN having an n_{b} of 2.45, the burying materials 3a and 3b preferably have an effective refractive index n_{b} of less than 2.52, such as Ga_{0. 98}Al_{0. 04}N doped with Mg mentioned above.

The both electrodes can have known structures and can be prepared from known materials. Examples thereof include Au for p-side electrode 5, and Al and In for n-side electrode 4.

In another embodiment shown in Fig. 2, unlike the embodiment in Fig. 1 wherein burying materials 3a and 3b having an effective refractive index which is lower than that of the active layer 2c and high electric resistance are filled to cover the entirety of the both sides of the stripe light emitting part 2, burying materials 3c and 3d having high electric resistance are filled to cover the both sides of the second cladding layer 2b alone. In this embodiment, the regions defined by the dashed lines 6 and 6, as well as regions 7 and 7 are composed of the same material. However, when the voltage is applied between the electrodes 4 and 5, the current is flown into the portion between the two dashed lines 6 and 6 in Fig. 2 which corresponds to the width l₁ (i.e., light emitting part 2) alone due to the presence of the burying materials 3c and 3d having high electric resistance, and the current is not flown through the regions 7 and 7. The vicinity of the dashed lines 6 and 6 substantially functions as the side walls dividing the stripe light emitting part 2.

In the embodiment of Fig. 2, when the burying materials 3c and 3d have high electric resistance, as well as effective refractive index n_{b} which is lower than nₐ of the active layer 2c, the material constituting the portions outside the dotted lines 6 and 6, namely, regions 7 and 7, has, despite the fact that the inside and outside of the dashed lines 6 and 6 are formed from the same material, a lower effective index n_{b} due to the close presence of the burying material having a low effective refractive index, which ultimately makes the difference Δ in effective refractive index fall within the aforementioned range, thereby preventing the occurrence of a higher order mode.

In the embodiment of Fig. 2, the second cladding layer 2b alone can be prepared by an etching treatment and deposition in the same manner as in Example 1. The following method is particularly preferable which obviates etching and facilitates manufacture.

For a simplified manufacture, a stripe processing is applied to the second cladding layer 2b alone. This method utilizes the fact that InGaAlN materials have high electric resistance after addition of p-type impurities, and they show p-type conductivity only after they have undergone appropriate post-treatments.

To be specific, when n-type crystal substrate 1 and an n-type first cladding layer 2a are used, p-type impurity such as Mg is added to the second cladding layer 2b, and the region inside the dashed lines 6 and 6 is subjected to the post-treatment to make said region p type. As a result, although the layer 2b is a flat layer composed of GaInP in the entirety thereof, only the region within the dashed lines 6 and 6 in the mid section functions as a p-type cladding layer, and the both sides thereof come to have high electric resistance, thus substantially functioning as the burying materials 3c and 3d. The post-treatment to impart the p-type conductivity may be performed by a known method, with preference given to electron beam irradiation which enables selective control of conductivity.

By the above-mentioned method of forming a stripe structure, process steps such as etching can be eliminated from the steps necessary for the embodiment of Fig. 1, and the production cost can be reduced. The embodiment of Fig. 1 is a high quality laser, since the sides of the stripe structure are filled with a material having high electric resistance and low refractive index.

The present invention can be modified in various ways besides Examples 1 and 2. The burying material may be used for optional portion within the light emitting part 2, such as each side of the first cladding layer, active layer and the second cladding layer. The use of a burying material having a high electric resistance and low refractive index as in the embodiment of Fig. 1 is particularly preferable in that it facilitates the production of the laser diode of the present invention.

## Claims

1. A laser diode comprising an electro-conductive substrate, an electrode formed on one side thereof, a stripe light emitting part having a double heterostructure formed on the other side of the substrate, and the other electrode formed on said light emitting part, wherein the light emitting part comprises a first cladding layer, an active layer composed of a compound semiconductor of the formula: InₓGa_{y}Al_{1-x-y}N (0≦x≦1, 0≦y≦1) and a second cladding layer in that order from the substrate side, and the stripe light emitting part is buried with a burying material having a high electric resistance.

2. The laser diode of Claim 1, wherein the burying material has an effective refractive index (n_{b}) which is 5×10⁻¹ - 5×10⁻⁴ lower than the effective refractive index (nₐ) of the active layer at a lasing wavelength.

3. The laser diode of Claim 1, wherein the second cladding layer in the stripe light emitting part is buried with the burying material.

4. The laser diode of Claim 2, wherein the first cladding layer, the active layer and the second cladding layer in the stripe light emitting part are buried with the burying material.

5. The laser diode of Claim 2, wherein the double heterostructure is an SCH structure.

6. The laser diode of Claim 2, wherein the electrode on the second cladding layer extends on a single plane and approximately in the entirety of the upper surface of the cladding layer.

7. The laser diode of Claim 3, wherein the substrate and the first cladding layer have n-type conductivity, and the second cladding layer is composed of an InGaAlN compound semiconductor added with a p-type impurity, wherein the region corresponding to the light emitting part has a p-type conductivity, with the rest having non-p-type conductivity and high electric resistance.

8. The laser diode of Claim 2, wherein the active layer is composed of InGaN and the cladding layer is composed of GaAlN.

9. The laser diode of Claim 2, wherein the electro-conductive substrate is composed of GaN or SiC.
